(19) **Europäisches Patentamt / European Patent Office / Office européen des brevets**

(11) **EP 2 027 476 B1**

(12) # FASCICULE DE BREVET EUROPEEN

(45) Date de publication et mention
de la délivrance du brevet:
**14.10.2009 Bulletin 2009/42**

(21) Numéro de dépôt: **07765336.8**

(22) Date de dépôt: **06.06.2007**

(51) Int Cl.:
*G01R 23/167* (2006.01)     *H04L 12/56* (2006.01)

(86) Numéro de dépôt international:
**PCT/EP2007/055612**

(87) Numéro de publication internationale:
**WO 2007/141311 (13.12.2007 Gazette 2007/50)**

(54) **SYSTEME D'EXTRACTION ET D'ANALYSE DE SIGNAUX RADIOELECTRIQUES D'INTERETS**

SYSTEM ZUR EXTRAKTION UND ANALYSE VON FUNKSIGNALEN

SYSTEM FOR EXTRACTION AND ANALYSIS OF RADIO SIGNALS

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **09.06.2006 FR 0605142**

(43) Date de publication de la demande:
**25.02.2009 Bulletin 2009/09**

(73) Titulaire: **THALES**
**92200 Neuilly sur Seine (FR)**

(72) Inventeurs:
- **GOGUILLON, Patrick**
  **F-92300 Levallois-Perret (FR)**
- **VIRAVAU, Philippe**
  **75001 Paris (FR)**
- **CAZENEUVE, Bruno**
  **F-91330 Yerres (FR)**
- **LAMELOT, Dominique**
  **F-92140 Clamart (FR)**
- **LEBOURG, Thierry**
  **F-95600 Eaubonne (FR)**

(74) Mandataire: **Lucas, Laurent Jacques**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A1- 5 748 507**

- **NOVELLINO J: "SPECTRUM ANALYZER COVERS 2 MHZ AT REAL-TIME SPEEDS" ELECTRONIC DESIGN, PENTON MEDIA, CLEVELAND, OH, US, vol. 36, no. 20, 8 septembre 1988 (1988-09-08), pages 121-123, XP000112183 ISSN: 0013-4872**
- **ROMANCHIK D: "DSP BOARDS EXPEDITE WAVEFORM ANALYSIS" ELECTRONICS TEST, MILLER FREEMAN, SAN FRANCISCO, US, vol. 10, no. 11, octobre 1990 (1990-10), pages 63-64,66,68, XP000160068 ISSN: 0164-9620**
- **ZIMMERMAN G A ET AL: "A 640 MHz 32 megachannel real-time polyphase-FFT spectrum analyzer" SIGNALS, SYSTEMS AND COMPUTERS, 1991. 1991 CONFERENCE RECORD OF THE TWENTY-FIFTH ASILOMAR CONFERENCE ON PACIFIC GROVE, CA, USA 4-6 NOV. 1991, LOS ALAMITOS, CA, USA,IEEE COMPUT. SOC, US, 4 novembre 1991 (1991-11-04), pages 106-110, XP010026279 ISBN: 0-8186-2470-1**

# Description

L'invention concerne un système d'extraction et d'analyse de signaux radioélectriques d'intérêts, c'est-à-dire les signaux correspondant à une ou plusieurs utilisations données du spectre. En particulier, l'invention s'applique au système de radio-surveillance des émissions radioélectriques en temps réel, temps contraint, ou en temps différé.

Dans le domaine de la radiosurveillance des émissions radiofréquences, notamment dans les applications de contrôle du spectre, il existe des systèmes dont l'architecture est adaptée au traitement en temps réel ou en temps différé de signaux d'intérêt présents dans un spectre large bande, c'est-à-dire compris entre quelques kilohertz et plusieurs centaines de mégahertz selon la gamme de fréquence observée. Ces systèmes de radiosurveillance ont notamment pour objet l'analyse et l'extraction des informations portées par tout ou partie des signaux présents dans ce spectre, comme par exemple un signal radio modulé en fréquence ou encore un signal de téléphonie mobile. Ces systèmes de radiosurveillance sont conçus pour travailler sur des gammes de fréquences variées, par exemple HF, VHF, UHF et SHF.

Les systèmes de radiosurveillance comportent des dispositifs d'acquisition de signaux radioélectriques, transformant un signal radioélectrique de nature analogique en un signal numérique. Pour ce faire, les systèmes de radiosurveillance utilisent des composants discrets de conversion analogique numérique, suivis éventuellement de composants numériques permettant une réduction de bande et une transposition en fréquence, désignés par l'expression anglo-saxonne « Digital Down Converter » permettant l'extraction d'un signal d'intérêt dans un spectre large bande.

Les systèmes de radiosurveillance comportent aussi des dispositifs de traitement et d'analyse des signaux radioélectriques permettant d'identifier, d'extraire et de caractériser les signaux dits d'intérêt. Pour cela, les systèmes de radiosurveillance utilisent des détecteurs pour mettre en évidence la présence d'un signal de radio-émission et des moyens de calculs numériques.

Les systèmes de radiosurveillance doivent faire face à une gamme d'utilisation du spectre de fréquence de plus en plus variée et de plus en plus étendue. En particulier, les architectures des dispositifs de traitement et d'analyse des signaux radioélectriques doivent pouvoir répondre aux exigences de traitement systématique, c'est-à-dire sans perte sensible d'informations, sur une bande de fréquence de plus en plus large. En outre, les systèmes de radiosurveillance doivent pouvoir extraire et traiter les signaux en bande étroite répartis sur ces larges bandes de fréquence.

Or, les systèmes de radiosurveillance utilisant des composants discrets de transposition et filtrage en fréquence, sont intrinsèquement limités par la bande passante des convertisseurs analogiques numériques et par le nombre de composants discrets mis en oeuvre ne permettant le traitement en parallèle que d'un nombre de signaux fixe, défini par la structure matérielle. Par ailleurs, les techniques actuelles sont fortement dépendantes des ressources matérielles disponibles.

La demande de brevet US-A1-5 748 507 divulgue un système de radiosurveillance comprenant un dispositif d'acquisition numérique connecté à un banc de filtres numériques parallèles pour sélectionner plusieurs bandes d'intérêt du signal reçu. Les données filtrées sont ensuite soumises à un traitement d'analyse du spectre parallèle en utilisant plusieurs modules multi-processeurs.

L'article de J. Novellino intitulé "Spectrum analyzer covers 2 Mhz at real-time speeds", Electronic Design, vol. 36, n° 20, 8.9.1988, pages 121-123, XP000112183 ISSN: 0013-4872 décrit un analysateur de spectre utilisant un banc de filtres parallèles pour extraire des sous-bandes utiles du signal reçu.

L'article de D. Romanchik intitulé "DSP boards expedite waveform analysis", Electronics Test, vol. 10, n° 11, octobre 1990, pages 63-64,66,68, XP000160068 ISSN: 0164-9620 divulgue l'utilisation de plusieurs circuits DSP reliés par connections en série pour augmenter la vitesse de traitement des signaux dans un analyseur de spectre.

L'article de Zimmerman intitulé "A 640 Mhz 32 megachannel real-time polyphase-FFT spectrum analyzer" dans Signals, Systems and Computers, 1991 Conference Record of the Twenty-fifth Asilomar Conference on Pacific Grove, IEEE COMPUTER SOC, 4.11.1991, pages 106-110, XP010026279 ISBN: 0-8186-2470-1 décrit un analyseur de spectre basé sur une architecture à transformation de Fourier de type polyphasé.

L'invention a notamment pour but de pallier les inconvénients précités. A cet effet, l'invention a notamment pour objet un système d'extraction et d'analyse de signaux radioélectriques d'intérêt comportant un nombre entier N de voies. Chaque voie $V_i$ comporte un récepteur relié à un dispositif d'acquisition numérique des signaux analogiques délivrant un signal numérique $SN_i$. Chaque voie $V_i$ comporte un banc de filtres polyphasés, un ou plusieurs signaux numériques extraits $SE_i$ étant extrait par le banc de filtres polyphasés du signal numérique $SN_i$ émis par le dispositif d'acquisition numérique des signaux analogiques. Les signaux numériques extraits $SE_i$ ont chacun une largeur de bande de fréquence inférieure à celle du signal numérique $SN_i$ reçu du dispositif d'acquisition numérique des signaux analogiques. Le système comporte au moins un dispositif de distribution des signaux numériques extraits adapté à recevoir les signaux numériques extraits $SE_i$ des bancs de filtres polyphasés et distribuer les signaux numériques extraits $SE_i$ des bancs de filtres polyphasés vers une ou plusieurs unités de traitement et de stockage. Les unités de traitement et de stockage sont adaptées à l'analyse, la caractérisation et le stockage des signaux numériques reçus.

Dans un mode de réalisation, les voies $V_i$ com-

portent un dispositif de sélection de la bande d'intérêt adapté à la réduction du signal numérique $SN_i$ délivré par un dispositif d'acquisition numérique des signaux analogiques à la bande de fréquence d'intérêt pour ladite voie ($V_i$). Cette bande d'intérêt peut être composée de plusieurs sous-bandes disjointes.

Chaque banc de filtres polyphasés peut opérer des traitements systématiques et continus sur le signal numérique $SN_i$ en sortie du dispositif d'acquisition numérique des signaux analogiques.

Avantageusement, le dispositif de distribution des signaux numériques extraits choisit l'une des unités de traitement et de stockage à laquelle un signal numérique extraits $SE_i$ doit être transmis en fonction de la spécialisation fonctionnelle et/ou de la disponibilité de ladite unité de traitement et de stockage.

Dans un autre mode de réalisation, e dispositif de distribution des signaux numériques extraits sélectionne et regroupe des signaux numériques extraits $SE_i$ en paquets avant de les transmettre aux unités de traitement et stockage, lesdits paquets étant construits en fonction des ressources et des médias physiques disponibles.

Avantageusement, le dispositif de stockage compris dans les unités de traitement et stockage permet la conservation en mémoire des données sur une durée paramétrable et la relecture ultérieure de ces données en fonction des besoins des traitements opérés en parallèle.

Dans un mode particulier de réalisation, les bancs de filtres polyphasés et/ou le dispositif de distribution des signaux numériques extraits sont compris dans un ou plusieurs composants à logique programmable. Le dispositif de distribution des signaux numériques extraits peut en outre être un commutateur IP.

Le système peut par exemple être utiliser pour convertir l'ensemble des signaux de radioélectriques en un flux de données retransmis sur un réseau numérique de type Internet ou encore pour convertir des signaux à multiplexage fréquentiel en signaux à multiplexage temporel. Le système peut aussi être utiliser pour mettre en oeuvre de traitements relatifs aux systèmes de communication à antennes multiples, et/ou de traitements relatifs à la goniométrie à haute résolution.

L'invention a notamment pour avantages que le nombre de canaux qu'elle permet de traiter à un instant donné n'est pas limité par la configuration matérielle de l'invention, mais uniquement par la bande passante des voies de communication vers les ressources de calcul et la capacité de traitement de ces ressources.

D'autres caractéristiques et avantages de l'invention apparaîtront à l'aide de la description qui suit, faite en regard des dessins annexés qui représentent :

- la figure 1, un système de radiosurveillance selon l'état de l'art ;

- la figure 2, un synoptique représentant un exemple d'architecture d'un système selon l'invention d'extraction et d'analyse de signaux radioélectriques d'intérêts sur une large bande de fréquence, adapté notamment à la radiosurveillance.

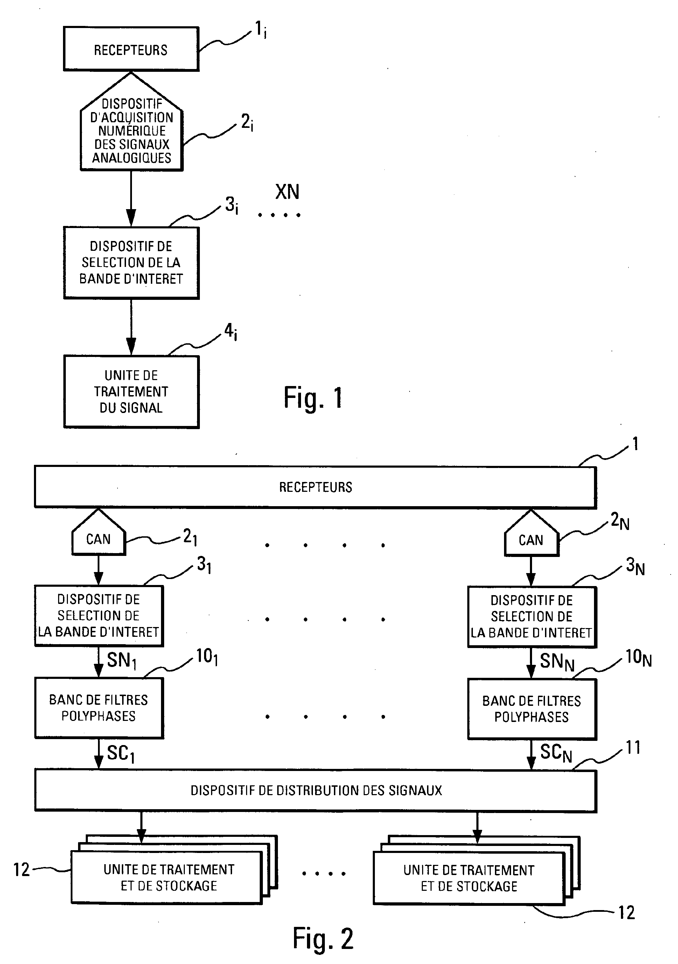

La figure 1 représente un système de radiosurveillance selon l'état de l'art. Un système de radiosurveillance a pour objet de détecter, d'extraire et de caractériser les signaux dits d'intérêt sur une zone géographique donnée. Pour cela, un système de radiosurveillance comporte un nombre n de récepteurs $1_1...1_n$ permettant de recevoir sous forme analogique un signal représentatif de l'environnement radioélectrique du système de radiosurveillance. Ces récepteurs $1_1...1_n$ sont typiquement des antennes ou plus généralement des réseaux d'antennes couplés à un étage de transposition et filtrage en fréquence. Le système de radiosurveillance selon l'état de l'art peut comporter un nombre entier N de voies, le nombre n de récepteurs $1_1...1_n$ étant égale à N.

Ainsi à chaque voie $V_i$, i étant un entier compris dans l'intervalle [1..N], correspond le récepteur $1_i$, un dispositif d'acquisition numérique des signaux analogiques $2_i$, un dispositif de sélection de la bande d'intérêt $3_i$ et une unité de traitement du signal $4_i$. Chaque récepteurs $1_i$ délivrent un signal analogique $SA_i$. Ce signal analogique $SA_i$ est alors converti en un signal numérique$_i$ par le dispositif d'acquisition numérique des signaux analogiques $2_i$. En particulier, le dispositif d'acquisition numérique des signaux analogiques $2_i$ comprend par exemple pour cela des composants de type convertisseurs analogique numérique. Le signal numérique issu du dispositif d'acquisition numérique des signaux analogiques $2_i$ est par exemple un signal numérique dont la bande de fréquence B est choisie en fonction des caractéristiques du récepteur $1_i$ et du convertisseur analogique numérique $2_i$. Aussi, ce signal numérique peut être limité par le dispositif de sélection de la bande d'intérêt $3_i$ à un signal numérique correspondant à une bande de fréquence d'intérêt BI plus réduite que la bande de fréquence B (BI<B), adaptée aux besoins et/ou aux capacités de calcul du système de radiosurveillance. Cette bande BI de fréquence d'intérêt peut être découpée en un ensemble de x bandes plus étroites de largeur identique aux signaux d'intérêt. Le dispositif de sélection de la bande d'intérêt comporte un nombre x de composants numériques discrets de transposition et filtrage en fréquence. Ce nombre x est fixe et défini par la structure matérielle. Les x signaux numériques limités à la bande de fréquence d'intérêt sont ensuite transmis à l'unité de traitement du signal $4_i$ qui va détecter, analyser et caractériser les éléments présents dans les x signaux numériques transmis pour mettre en valeur les éléments pertinents.

Chaque voie $V_i$ est dédiée à l'analyse d'une bande de fréquence donnée de l'environnement électromagnétique. Chacune des N voies $V_i$ peut être dédiée à une bande d'intérêt différente pour chaque voie $V_i$, ou au contraire plusieurs voies $V_i$ peuvent être couplées, c'est-à-dire mises en cohérence, pour permettre des traitements multi-voies comme de la radiogoniométrie conventionnelle ou haute résolution, du filtrage spatial, de la séparation de sources. Les capacités d'analyse du système de radiosurveillance sont donc intrinsèquement limitées par la bande passante des convertisseurs analogique numérique du dispositif d'acquisition numérique des signaux analogiques $2_i$ et par le nombre x de composants discrets mis en oeuvre par le dispositif de sélection de la bande d'intérêt $3_i$ pour une voie $V_i$ donnée. Le système de radiosurveillance selon l'état de l'art ne permet donc le traitement en parallèle que d'un nombre de signaux d'intérêt fixe, soit N X x, défini par la structure matérielle de chaque voie $V_i$ et du nombre N de voies. Il en résulte encore que le système de radiosurveillance selon l'état de l'art est fortement dépendant des ressources matérielles disponibles, au niveau des dispositifs $2_i$, $3_i$ et $4_i$.

La figure 2 illustre un exemple d'architecture d'un système, selon l'invention, d'extraction et d'analyse de signaux radioélectriques d'intérêts sur une large bande de fréquence, adaptée notamment à la radiosurveillance. Les éléments identiques aux éléments déjà présentés sur les autres figures portent les mêmes références. Le système selon l'invention d'extraction et d'analyse de signaux radioélectriques d'intérêts comporte un nombre entier N de voies, chaque voie $V_i$ (i étant un entier compris dans l'intervalle [1..N]) comportant un récepteur $1_i$, un dispositif d'acquisition numérique des signaux analogiques $2_i$ d'une bande B, et un dispositif de sélection de la bande d'intérêt BI $3_i$ adapté à la réduction du signal numérique délivré par un dispositif d'acquisition numérique des signaux analogiques $2_i$ à la bande de fréquence d'intérêt pour ladite voie $V_i$. Cette bande d'intérêt BI peut être composée de plusieurs sous-bandes disjointes. Chaque voie $V_i$ comporte en outre un banc de filtres polyphasés $10_i$. Le signal reçu par le banc de filtres polyphasés est un signal numérique $SN_i$ de large bande de fréquence BI éventuellement composé de plusieurs sous-bandes. Le banc de filtres polyphasés $10_i$ opère des traitements systématiques et continus sur le signal numérique $SN_i$ en sortie du dispositif de sélection de la bande d'intérêt BI $3_i$. Le banc de filtres polyphasés $10_i$ effectue des traitements continus sur l'ensemble de la bande de fréquence d'intérêt. Le banc de filtres polyphasés $10_i$ permet notamment de découper le signal numérique $SN_i$ correspondant à la bande d'intérêt BI en un nombre entier p de signaux numériques extraits $SE_i$ cohérents dont la bande de fréquence b est réduite, relativement au signal numérique $SN_i$ d'entrée du banc de filtres polyphasés $10_i$, tel que la relation suivante soit vérifiée :

$$BI = p \times b.$$

En fonction de la configuration du banc de filtres polyphasés $10_i$, il est possible de reconstituer tout ou partie du signal d'origine large bande avec une dégradation contrôlée dépendant principalement des paramètres du banc de filtre polyphasés $10_i$. Le passage du signal numérique-$SN_i$ reçu par le banc de filtres polyphasés $10_i$ à plusieurs signaux numériques extraits $SE_i$ est dimensionné pour que la dégradation n'impacte pas les traitements mis en oeuvre en aval.

Dans un mode de réalisation, le banc de filtres polyphasés $10_i$ comporte un ou plusieurs composants à logique programmable de type FPGA ou ASIC dans le cas des systèmes temps réel notamment, ou sur des processeurs généralistes dans le cas de traitements temps contraint ou temps différé.

Le système comporte un dispositif de distribution des signaux numériques extraits 11, prenant en compte les N voies du système. Les signaux numériques extraits $SE_i$ au niveau des bancs de filtres polyphasés $10_i$ sont ensuite transmis au dispositif de distribution des signaux numériques extraits 11. En fonction du besoin et de l'application finale, le dispositif de distribution des signaux numériques extraits 11 est programmé pour sélectionner et distribuer les signaux numériques extraits $SE_i$ d'intérêt aux unités de traitement et stockage 12. Le dispositif de distribution des signaux numériques extraits 11 choisit donc l'une des unités de traitement et de stockage 12 à laquelle l'un des signaux numériques extraits $SE_i$ doit être transmis en fonction de la spécialisation fonctionnelle et/ou de la disponibilité de ladite unité de traitement et de stockage 12. Ainsi, si une unité de traitement et de stockage 12 ne dispose plus de ressources suffisantes (calculatoire ou de stockage par exemple), le dispositif de distribution des signaux numériques extraits 11 peut être reconfiguré pour allouer les traitements à d'autres unités disposant des ressources nécessaires. Le dispositif de distribution des signaux numériques extraits 11 peut en outre regrouper les signaux numériques extraits $SE_i$ en paquets avant de les transmettre pour optimiser la bande passante et le taux d'occupation du lien le reliant aux unités de traitement et de stockage 12.

Les unités de traitement et de stockage 12 sont par exemple être des ordinateurs classiques, de type ordinateur personnel (PC), afin notamment d'optimiser le rapport coût/performance de la solution en comparaison notamment des machines dédiées de traitement du signal (ou selon l'expression anglo-saxonne Digital Signal Processor). Ces signaux numériques extraits $SE_i$, plus étroits que le signal numérique entrant dans le banc de filtres polyphasés $10_i$, peuvent alors être traités en parallèle par des unités de traitement et de stockage 12, qui peuvent être des ressources de calcul banalisées.

A titre d'exemple non limitatif, les unités de traitement et de stockage 12 peuvent réaliser au moins l'une des tâches traitement du signal, sur un ou plusieurs signaux radioélectriques, de détection d'émission, de segmentation, de reconnaissance de la modulation, d'identification de forme d'onde, de goniométrie, de localisation, de formation de faisceau, de démodulation d'émissions fréquence fixe, de démodulation des émissions à multiplexage temporel et fréquentiel, de mesures techniques de type « UIT », de mémorisation tampon ( « buffer » selon l'expression anglo-saxonne) du signal sur une durée paramétrable, d'enregistrement de signaux bande étroite et/ou large bande...

Le dispositif de distribution des signaux numériques extraits 11 distribue par des voies de communication les signaux numériques extraits $SE_i$ en sortie du banc de filtres polyphasés $10_i$ sur des unités de traitement en fonction de l'application visée. Ainsi, en fonction du media de communication, la localisation physique des différentes unités de traitement et de stockages 11 n'est donc pas nécessairement unique. Les unités de traitement et de stockage 12 peuvent donc être réparties en plusieurs zones géographiques distinctes, séparé selon les besoins de quelques dizaines de mètres à plusieurs milliers de kilomètres. Le dispositif de distribution des signaux numériques extraits 11 permet encore de dissocier les unités de traitement et de stockage 12 des autres éléments compris dans le système selon l'invention d'extraction et d'analyse de signaux radioélectriques d'intérêts sur une large bande de fréquence. Ainsi, les unités de traitement et de stockage 12 peuvent être séparées physiquement des autres éléments du système.

Par ailleurs, le dispositif de distribution des signaux numériques extraits 11 est commun à l'ensemble des N voies comprises dans le système selon l'invention. Il permet donc de mutualiser les ressources de calcul et de stockage disponibles entre l'ensemble des voies, et ainsi améliorer notamment la disponibilité du système. Le système permet aussi d'adapter les ressources de traitements au nombre des émissions d'intérêt. Ainsi, en fonction des besoins il est très aisé d'adjoindre une nouvelle unité de traitement et de stockage banalisée 12 si les besoins opérationnels le justifient.

Le dispositif de distribution des signaux numériques extraits 11 peut être mis en oeuvre à l'aide de commutateurs IP (ou « switches Ethernet » selon l'expression anglo-saxonne) ou dans un ou plusieurs composants à logique programmable de type FPGA ou ASIC notamment, éventuellement dans le même composant logique programmable que le banc de filtres polyphasés 10.

Le système selon l'invention utilise des banc de filtres polyphasés $10_i$ découpant un signal réparti sur une large bande de fréquence en un nombre p de signaux de bande de fréquence plus étroite. En fonction de la configuration du dispositif de distribution 11, les unités de traitement et de stockage 11 peuvent donc reconstituer tout ou partie du signal d'origine à large bande de fréquence avec une dégradation contrôlée dépendant des paramètres du banc de filtre $10_i$. De plus, les unités de traitement et de stockage 11 en combinant les signaux de bande de fréquences plus étroite de l'ensemble des bancs de filtres $10_i$ d'un ensemble des K voies, avec K≤ N, du système peuvent reconstituer un signal large-bande dont la bande passante est K fois plus grande que la bande passante d'intérêt BI traitée par un seul banc de filtre $10_i$.

Le système selon l'invention est notamment adapté à la sélection des signaux de bande étroite en fonction de leur intérêt, à la diffusion de signaux par paquets sur des ressources de traitement et de stockage, au traitement dans le flux des paquets de signaux reçus par les ressources de traitement, à l'accès à la zone de stockage ou à la mémoire tampon pour extraire des signaux préalablement stockés, à la régénération de tout ou partie du signal large bande à partir de ces signaux bande étroite, et à l'exécution de traitements du signal sur ces données régénérées.

Le système selon l'invention peut être utilisé pour contrôler les attributions de bande de fréquences à un opérateur par un organisme de contrôle du spectre. Le système selon l'invention peut aussi être mis en oeuvre pour convertir l'ensemble des signaux de radio en un flux de données retransmis par exemple sur un réseau de type Internet. Le système selon l'invention peut encore être utilisé pour convertir des signaux à multiplexage fréquentielle (ou selon l'expression anglo-saxonne Frequency-Division Multiple Access ) en signaux à multiplexage temporel (ou selon l'expression anglo-saxonne Time-Division Multiple Access). Le système selon l'invention peut aussi être utilisé pour la mise en oeuvre de traitements relatifs aux systèmes de communication à antennes multiples (ou selon l'expression anglo-saxonne Multi-Input Multiple-Output), ou encore dans le cadre de traitements de goniométrie à haute résolution.

**Revendications**

1. Système d'extraction et d'analyse de signaux radioélectriques d'intérêt comportant un nombre entier N de voies, chaque voie ($V_i$) comportant un récepteur ($1_i$) relié à un dispositif d'acquisition numérique des signaux analogiques ($2_i$) délivrant un signal numérique $SN_i$, **caractérisé en ce que** chaque voie ($V_i$) comporte un banc de filtres polyphasés ($10_i$), un ou plusieurs signaux numériques extraits $SE_i$ étant extrait par le banc de filtres polyphasés (10) du signal numérique $SN_i$ émis par le dispositif d'acquisition numérique des signaux analogiques (2), lesdits signaux numériques extraits $SE_i$ ayant chacun une largeur de bande de fréquence inférieure à celle du signal numérique $SN_i$ reçu du dispositif d'acquisition numérique des signaux analogiques ($2_i$), le système étant **caractérisé en ce qu'**il comporte au moins un dispositif de distribution des signaux numériques extraits (11) adapté à :

   • recevoir les signaux numériques extraits $SE_i$ des bancs de filtres polyphasés ($10_i$) et ;
   • distribuer les signaux numériques extraits $SE_i$ des bancs de filtres polyphasés ($10_i$) vers une ou plusieurs unités de traitement et de stockage (12), lesdites unités de traitement et de stockage (12) étant adaptées à l'analyse, la caractérisation et le stockage des signaux numériques reçus.

2. Système selon la revendication 1 **caractérisé en ce que** les voies ($V_i$) comportent un dispositif de sélection de la bande d'intérêt ($3_i$) adapté à la réduction du signal numérique $SN_i$ délivré par un dispositif d'acquisition numérique des signaux analogiques (2) à la bande de fréquence d'intérêt pour ladite voie ($V_i$), cette bande d'intérêt pouvant être composée de plusieurs sous-bandes disjointes.

3. Système selon l'une quelconque des revendications 1 à 2 **caractérisé en ce que** chaque banc de filtres polyphasés ($10_i$) opère des traitements systématiques et continus sur le signal numérique $SN_i$ en sortie du dispositif d'acquisition numérique des signaux analogiques ($2_i$).

4. Système selon l'une quelconque des revendications 1 à 3 **caractérisé en ce que** le dispositif de distribution des signaux numériques extraits (11) choisit l'une des unités de traitement et de stockage (12) à laquelle un signal numérique extraits $SE_i$ doit être transmis en fonction de la spécialisation fonctionnelle et/ou de la disponibilité de ladite unité de traitement et de stockage (12).

5. Système selon l'une quelconque des revendications 1 à 4 **caractérisé en ce que** le dispositif de distribution des signaux numériques extraits (11) sélectionne et regroupe des signaux numériques extraits $SE_i$ en paquets avant de les transmettre aux unités de traitement et stockage (12), lesdits paquets étant construits en fonction des ressources et des médias physiques disponibles.

6. Système selon l'une quelconque des revendications 1 à 5 **caractérisé en ce que** le dispositif de stockage compris dans les unités de traitement et stockage (12) permet la conservation en mémoire des données sur une durée paramétrable et la relecture ultérieure de ces données en fonction des besoins des traitements opérés en parallèle.

7. Système selon l'une quelconque des revendications 1 à 6 **caractérisé en ce que** les bancs de filtres polyphasés ($10_i$) et/ou le dispositif de distribution des signaux numériques extraits (11) sont compris dans un ou plusieurs composants à logique programmable.

8. Système selon l'une quelconque des revendications 1 à 7 **caractérisé en ce que** le dispositif de distribution des signaux numériques extraits (10) est un commutateur IP.

9. Utilisation du système selon l'une quelconque des revendications 1 à 8 pour convertir l'ensemble des signaux de radioélectriques en un flux de données retransmis sur un réseau numérique de type Internet.

10. Utilisation du système selon l'une quelconque des revendications 1 à 8 pour convertir des signaux à multiplexage fréquentiel en signaux à multiplexage temporel.

11. Utilisation du système selon l'une quelconque des revendications 1 à 8 pour mettre en oeuvre de traitements relatifs aux systèmes de communication à antennes multiples, et/ou de traitements relatifs à la goniométrie à haute résolution.

**Claims**

1. System for extracting and analyzing radioelectric signals of interest comprising an integer number N of pathways, each pathway ($V_i$) comprising a receiver ($1_i$) linked to an analog signals digital acquisition device ($2_i$) delivering a digital signal $SN_i$, **characterized in that** each pathway ($V_i$) comprises a bank of polyphase filters ($10_i$), one or more extracted digital signals $SE_i$ being extracted by the bank of polyphase filters (10) from the digital signal $SN_i$ emitted by the analog signals digital acquisition device (2), said extracted digital signals $SE_i$ each having a smaller frequency bandwidth than that of the digital signal $SN_i$ received from the analog signals digital acquisition device ($2_i$), the system being **characterized in that** it comprises at least one extracted digital signals distribution device (11) suited to:

   • receiving the digital signals extracted $SE_i$ from the polyphase filter banks ($10_i$) and;
   • distributing the digital signals extracted $SE_i$ from the polyphase filter banks ($10_i$) to one or more processing and storage units (12), said processing and storage units (12) being suitable for the analysis, characterization and storage of the digital signals received.

2. System according to Claim 1, **characterized in that** the pathways ($V_i$) comprise a device for selecting the band of interest ($3_i$) suitable for reducing the digital signal $SN_i$ delivered by an analog signals digital acquisition device (2) to the frequency band of interest for said pathway ($V_i$), this band of interest possibly being composed of several disjoint sub-bands.

3. System according to either of Claims 1 and 2, **characterized in that** each bank of polyphase filters ($10_i$) carries out systematic and continuous processing operations on the digital signal $SN_i$ output from the

analog signals digital acquisition device ($2_i$).

4. System according to any one of Claims 1 to 3, **characterized in that** the extracted digital signals distribution device (11) chooses one of the processing and storage units (12) to which a digital signal extracted $SE_i$ must be transmitted as a function of the functional specialization and/or of the availability of said processing and storage unit (12).

5. System according to any one of Claims 1 to 4, **characterized in that** the extracted digital signals distribution device (11) selects extracted digital signals $SE_i$ and groups them together into packets before transmitting them to the processing and storage units (12), said packets being constructed as a function of the resources and of the physical media available.

6. System according to any one of Claims 1 to 5, **characterized in that** the storage device included in the processing and storage units (12) allows the data to be preserved in memory over a parametrizable duration and these data to be subsequently re-read depending on the requirements of the processing operations carried out in parallel.

7. System according to any one of Claims 1 to 6, **characterized in that** the polyphase filter banks ($10_i$) and/or the extracted digital signals distribution device (11) are included in one or more programmable-logic components.

8. System according to any one of Claims 1 to 7, **characterized in that** the extracted digital signals distribution device (10) is an IP switch.

9. Use of the system according to any one of Claims 1 to 8 to convert the set of radioelectric signals into a data stream retransmitted on a digital network of Internet type.

10. Use of the system according to any one of Claims 1 to 8 to convert frequency division multiplexed signals into time division multiplexed signals.

11. Use of the system according to any one of Claims 1 to 8 to implement processing operations relating to multi-antenna communication systems, and/or processing operations relating to high-resolution goniometry.

**Patentansprüche**

1. System zur Entnahme und Analyse zweckentsprechender Funksignale, das eine gerade Anzahl N von Kanälen aufweist, wobei jeder Kanal ($V_i$) einen Empfänger ($1_i$) aufweist, der mit einer Vorrichtung zur digitalen Erfassung der analogen Signale ($2_i$) verbunden ist, die ein digitales Signal $SN_i$ liefert, **dadurch gekennzeichnet, dass** jeder Kanal ($V_i$) eine Bank von Mehrphasenfiltern ($10_i$) aufweist, wobei eines oder mehrere entnommene Signale $SE_i$ von der Bank von Mehrphasenfiltern (10) aus dem von der Vorrichtung zur digitalen Erfassung der analogen Signale (2) ausgegebenen digitalen Signal $SN_i$ entnommen werden, wobei die entnommenen digitalen Signale $SE_i$ je eine geringere Frequenzbandbreite als diejenige des von der Vorrichtung zur digitalen Erfassung der analogen Signale ($2_i$) empfangenen digitalen Signals $SN_i$ haben, wobei das System **dadurch gekennzeichnet ist, dass** es mindestens eine Vorrichtung zur Verteilung der entnommenen digitalen Signale (11) aufweist, die geeignet ist, um:

• die entnommenen digitalen Signale $SE_i$ von den Mehrphasenfilterbanken ($10_i$) zu empfangen, und
• die entnommenen digitalen Signale $SE_i$ von den Mehrphasenfilterbanken ($10_i$) an eine oder mehrere Verarbeitungs- und Speichereinheiten (12) zu verteilen, wobei die Verarbeitungs- und Speichereinheiten (12) für die Analyse, die Kennzeichnung und die Speicherung der empfangenen digitalen Signale geeignet sind.

2. System nach Anspruch 1, **dadurch gekennzeichnet, dass** die Kanäle ($V_i$) eine Vorrichtung zur Auswahl des zweckentsprechenden Bands ($3_i$) aufweisen, die für die Reduzierung des von einer Vorrichtung zur digitalen Erfassung der analogen Signale (2) gelieferten digitalen Signals $SN_i$ auf das zweckentsprechende Frequenzband für den Kanal ($V_i$) geeignet ist, wobei dieses zweckentsprechende Band aus mehreren getrennten Subbändern bestehen kann.

3. System nach einem der Ansprüche 1 bis 2, **dadurch gekennzeichnet, dass** jede Bank von Mehrphasenfiltern ($10_i$) systematische und kontinuierliche Verarbeitungen am digitalen Signal $SN_i$ am Ausgang der Vorrichtung zur digitalen Erfassung der analogen Signale ($2_i$) durchführt.

4. System nach einem der Ansprüche 1 bis 3, **dadurch gekennzeichnet, dass** die Vorrichtung zur Verteilung der entnommenen digitalen Signale (11) eine der Verarbeitungs- und Speichereinheiten (12), an die ein entnommenes digitales Signal $SE_i$ übertragen werden soll, in Abhängigkeit von der funktionalen Spezialisierung und/oder der Verfügbarkeit der Verarbeitungs- und Speichereinheit (12) auswählt.

5. System nach einem der Ansprüche 1 bis 4, **dadurch gekennzeichnet, dass** die Vorrichtung zur Verteilung der entnommenen digitalen Signale (11) ent-

nommene digitale Signale SE$_i$ auswählt und in Paketen zusammenfasst, ehe sie an die Verarbeitungs- und Speichereinheiten (12) übertragen werden, wobei die Pakete in Abhängigkeit von den verfügbaren Ressourcen und physikalischen Medien konstruiert werden.

6. System nach einem der Ansprüche 1 bis 5, **dadurch gekennzeichnet, dass** die in den Verarbeitungs- und Speichereinheiten (12) enthaltene Speichervorrichtung die Aufbewahrung von Daten im Speicher über eine parametrierbare Dauer und das spätere nochmalige Lesen dieser Daten in Abhängigkeit von den Bedürfnissen der parallel durchgeführten Verarbeitungen erlaubt.

7. System nach einem der Ansprüche 1 bis 6, **dadurch gekennzeichnet, dass** die Mehrphasenfilterbänke (10$_i$) und/oder die Vorrichtung zur Verteilung der entnommenen digitalen Signale (11) sich in einem oder mehreren Bauteilen mit programmierbarer Logik befinden.

8. System nach einem der Ansprüche 1 bis 7, **dadurch gekennzeichnet, dass** die Vorrichtung zur Verteilung der entnommenen digitalen Signale (10) ein IP-Schalter ist.

9. Verwendung des Systems nach einem der Ansprüche 1 bis 8, um die Gesamtheit der funkelektrischen Signale in einen Datenstrom umzuwandeln, der an ein digitales System vom Typ Internet übertragen wird.

10. Verwendung des Systems nach einem der Ansprüche 1 bis 8 zur Umwandlung der Frequenzmultiplexsignale in Zeitmultiplexsignale.

11. Verwendung des Systems nach einem der Ansprüche 1 bis 8 zur Durchführung von Verarbeitungen bezüglich der Kommunikationssysteme mit mehreren Antennen und/oder von Verarbeitungen bezüglich der hochauflösenden Goniometrie.

Fig. 1

Fig. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5748507 A1

**Littérature non-brevet citée dans la description**

- **J. Novellino.** Spectrum analyzer covers 2 Mhz at real-time speeds. *Electronic Design,* 1988, vol. 36 (20), ISSN 0013-4872, 121-123
- **D. Romanchik.** DSP boards expedite waveform analysis. *Electronics Test,* Octobre 1990, vol. 10 (11), ISSN 0164-9620, 63-6466, 68

- A 640 Mhz 32 megachannel real-time polyphase-FFT spectrum analyzer. **Zimmerman.** Signals, Systems and Computers, 1991 Conference Record of the Twenty-fifth Asilomar Conference on Pacific Grove. IEEE COMPUTER SOC, 1991, 106-110